(19) Europäisches Patentamt
European Patent Office
Office européen des brevets

(11) EP 4 442 865 A1

# (12) EUROPEAN PATENT APPLICATION
published in accordance with Art. 153(4) EPC

(43) Date of publication:
**09.10.2024 Bulletin 2024/41**

(21) Application number: **22901738.9**

(22) Date of filing: **30.11.2022**

(51) International Patent Classification (IPC):
***C25B 11/032*** *(2021.01)* ***C25B 1/04*** *(2021.01)*
***C23C 16/448*** *(2006.01)*

(52) Cooperative Patent Classification (CPC):
**C23C 16/448; C25B 1/04; C25B 11/032**

(86) International application number:
**PCT/KR2022/019144**

(87) International publication number:
**WO 2023/101380 (08.06.2023 Gazette 2023/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.11.2021 KR 20210169323**

(71) Applicants:
- **Hanwha Solutions Corporation**
  **Jung-gu**
  **Seoul 04541 (KR)**
- **Korea Advanced Institute of Science and Technology**
  **Daejeon 34141 (KR)**

(72) Inventors:
- **OH, Myung Seok**
  **Daejeon 34128 (KR)**
- **PARK, Joung Hoon**
  **Daejeon 34128 (KR)**
- **KIM, Do Heung**
  **Daejeon 34128 (KR)**
- **KIM, Eui-Duk**
  **Daejeon 34128 (KR)**
- **PARK, Sarang**
  **Daejeon 34128 (KR)**
- **JEON, Hyojin**
  **Daejeon 34128 (KR)**
- **IM, Sung Gap**
  **Daejeon 34141 (KR)**
- **RYU, Jin**
  **Daejeon 34141 (KR)**

(74) Representative: **Berggren Oy**
**P.O. Box 16**
**Eteläinen Rautatiekatu 10A**
**00101 Helsinki (FI)**

# (54) GAS DIFFUSION LAYER FOR ANION EXCHANGE MEMBRANE ELECTROLYSIS AND MANUFACTURING METHOD THEREFOR

(57) The present invention relates to a gas diffusion layer for anion exchange membrane electrolysis which is hydrophilic and has alkali resistance, and further maintains high porosity and low electrical resistance, and a manufacturing method therefor.

【FIG. 1】

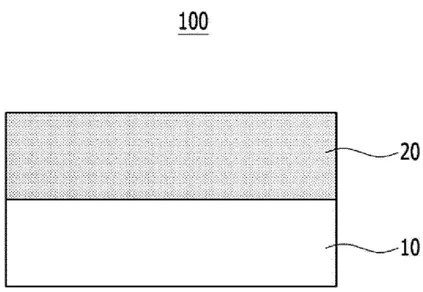




Processed by Luminess, 75001 PARIS (FR)

## Description

### [TECHNICAL FIELD]

CROSS-REFERENCE TO RELATED APPLICATION(S)

This application claims the benefit of Korean Patent Application No. 10-2021-0169323 filed on November 30, 2021 in the Korean Intellectual Property Office, the disclosure of which is incorporated herein by reference in its entirety.

The present invention relates to a gas diffusion layer for anion exchange membrane electrolysis and a manufacturing method therefor.

### [BACKGROUND]

The gas diffusion layer(GDL) serves as a passage that transmits reactants from a fuel cell(FC) and electrolysis(EC) to an electrode and simultaneously discharges products, and also is a key component that plays roles such as heat dissipation and electrode support.

Most of commercial GDLs are for polymer electrolyte membrane fuel cells(PEMFC) and have a structure in which a microporous layer(MPL) containing a hydrophobic polymer is coated onto a porous carbon paper. At this time, in the case of a fuel cell, a phenomenon (water flooding) may occur where water generated at the cathode blocks the pores of the gas diffusion layer, and thus the gas diffusion layer is required to have hydrophobicity. Therefore, the gas diffusion layer of the fuel cell uses PTFE and a binder as a polymer to impart hydrophobicity.

However, in the case of anion exchange membrane electrolysis, smooth movement of the electrolyte is required, and therefore, unlike a fuel cell, a hydrophobic gas diffusion layer is not suitable. In other words, it is necessary to improve wettability with electrolyte in terms of mass transfer. For this purpose, it is advantageous according as the hydrophilicity of the gas diffusion layer increases. In addition, since a highly concentrated KOH aqueous solution is used as the electrolyte, it is preferable that the gas diffusion layer has high alkali resistance.

Therefore, there is a need to develop a gas diffusion layer that is hydrophilic and has high alkali resistance that can be used in anion exchange membrane electrolysis.

### [DETAILED DESCRIPTION OF THE INVENTION]

### [Technical Problem]

It is an object of the present invention to provide a gas diffusion layer for anion exchange membrane electrolysis and a manufacturing method therefor.

Specifically, it is an object of the present invention to provide a gas diffusion layer for anion exchange membrane electrolysis which is hydrophilic and has alkali resistance, and further maintains high porosity and low electrical resistance, and a manufacturing method therefor.

### [Technical Solution]

According to one embodiment of the present invention, there is provided a gas diffusion layer for anion exchange membrane electrolysis comprising: a porous support; and a polymer thin film deposited on the whole or a part of the surface of the porous support, wherein the polymer thin film includes at least one functional group selected from the group consisting of amine, hydroxyl, ester, acid anhydride, carboxyl, epoxy, and pyridine.

According to another embodiment of the present invention, there is provided a method for manufacturing a gas diffusion layer for anion exchange membrane electrolysis, the method comprising: preparing a porous support (step 1); and forming a polymer thin film deposited on the whole or a part of the surface of the porous support using an initiated chemical vapor deposition (iCVD) (step 2).

### [Advantageous Effects]

In accordance with the present invention, a gas diffusion layer for anion exchange membrane electrolysis which is hydrophilic and has alkali resistance can be provided.

Also, in accordance with the present invention, a gas diffusion layer for anion exchange membrane electrolysis which maintains high porosity and low electrical resistance can be provided.

In addition, in accordance with the present invention, a method for manufacturing a gas diffusion layer for anion exchange membrane electrolysis using an initiated chemical vapor deposition can be provided.

Further, in accordance with the present invention, since the gas diffusion layer is manufactured using an initiated chemical vapor deposition, the whole of the porous support can be effectively surface modified at a very thin thickness.

**[BRIEF DESCRIPTION OF THE DRAWINGS]**

FIG. 1 is a schematic diagram of a gas diffusion layer for anion exchange membrane electrolysis according to an embodiment of the present invention.
FIG. 2 is a schematic diagram of a gas diffusion layer for anion exchange membrane electrolysis according to another embodiment of the present invention.
FIG. 3 shows surface observation images of a porous support before and after deposition of a thin polymer film according to an embodiment of the present invention through a scanning electron microscope (SEM).
FIG. 4 shows an observation image through a contact angle analyzer (DSA, KRUSS) to measure the contact angle of the carbon paper of a comparative example of the present invention.
FIG. 5 shows an observation image through a contact angle analyzer (DSA, KRUSS) to measure the contact angle of a gas diffusion layer in which a microporous layer was formed on one surface of carbon paper in a comparative example of the present invention.
FIG. 6 shows an observation image through a contact angle analyzer (DSA, KRUSS) to measure the contact angle of the gas diffusion layer on which a polymer thin film is formed on one surface of carbon paper in an embodiment of the present invention.
FIG. 7 shows an observation image through a contact angle analyzer (DSA, KRUSS) to measure the contact angle of a gas diffusion layer on which a microporous layer is formed on one surface of the carbon paper of an embodiment of the present invention and a polymer thin film is formed thereon.
FIG. 8 is a graph showing FT-IR measurement results before and after an alkali resistance test of a gas diffusion layer in which a polymer thin film is formed on one surface of carbon paper in an embodiment of the present invention.
FIG. 9 shows the results of measuring the average electrical resistance value compared to the compression rate in an experimental example of the present invention.
FIG. 10 shows the results of measuring the average electrical resistance value compared to the compression ratio in an experimental example of the present invention.
FIG. 11 shows the results of measuring the average electrical resistance value compared to the compression ratio in an experimental example of the present invention.
FIG. 12 shows the results of measuring the average electrical resistance value compared to the compression ratio in an experimental example of the present invention.
FIG. 13 shows the results of measuring the gas permeability in an experimental example of the present invention.

**[DETAILED DESCRIPTION OF THE EMBODIMENTS]**

The terms "first", "second", etc. may be used herein to describe various elements, and these terms are used to distinguish one element from another.

Also, the terminology used herein is for the purpose of describing particular example embodiments only and is not intended to be limiting of the invention. As used herein, the singular forms "a," "an" and "the" are intended to include the plural forms as well, unless the context clearly indicates otherwise. It will be further understood that the terms "include," "comprise," or "have" when used herein, specify the presence of stated features, numbers, steps, elements, or combinations thereof, but do not preclude the presence or addition of one or more other features, numbers, steps, elements, or combinations thereof.

Also, it means that, when each layer or element is referred to as being formed "on" or "top" of the respective layers or elements, each layer or element is formed on the top of the respective layers or elements, or the other layer or element may be additionally formed between the respective layers, or on the object or the substrate.

While the present invention is susceptible to various modifications and alternative forms, specific embodiments will be illustrated and described in detail as follows. It should be understood, however, that the description is not intended to limit the present invention to the particular forms disclosed herein, but the intention is to cover all modifications, equivalents, and replacements falling within the spirit and scope of the invention.

In the anion exchange membrane electrolysis, as the hydrophilicity of the gas diffusion layer increases, the wettability and permeability of the electrolytic solution increase, and thus the efficiency of the cell can increase. Therefore, the existing gas diffusion layer for fuel cells having a hydrophobic microporous layer reduces the wettability of the electrolyte solution, and at the same time, the thickness of the microporous layer, which reaches several tens of micrometers ($\mu$m), can also be a cause of decreasing the porosity of the porous support of the gas diffusion layer.

Therefore, the hydrophilic surface modification of the porous supports through thin nanometer-scale polymer thin films is required. In addition, during the water electrolysis process, especially in the case of anion exchange membrane water electrolysis, a highly concentrated KOH aqueous solution is used as the electrolytic solution, and thus the polymer thin film needs to have high alkali resistance in addition to hydrophilicity.

Below, the gas diffusion layer for anion exchange membrane electrolysis of the present invention will be discussed in more detail.

The present invention seeks to provide a gas diffusion layer for anion exchange membrane electrolysis which is hydrophilic and has high alkali resistance, and further maintains high porosity and low electrical resistance.

FIG. 1 is a schematic diagram of a gas diffusion layer for anion exchange membrane electrolysis according to an embodiment of the present invention.

The present invention seeks to provide a gas diffusion layer 100 for anion exchange membrane electrolysis comprising: a porous support 10, and a polymer thin film 20 deposited on the whole or a part of the surface of the porous support, wherein the polymer thin film includes at least one functional group selected from the group consisting of amine, hydroxyl, ester, acid anhydride, carboxyl, epoxy, and pyridine.

The functional group contained in the polymer thin film 20 can impart hydrophilic properties to the polymer thin film and also impart high alkali resistance.

Moreover, the polymer thin film 20 may have a thickness of 10 to 200 nm. Specifically, the polymer thin film may have a thickness of 10 nm or more, 25 nm or more, 50 nm or more, 75 nm or more, or 100 nm or more, and 200 nm or less, 175 nm or less, 150 nm or less, or 125 nm or less.

Further, the polymer thin film 20 may include repeating units derived from one or more monomers selected from the group consisting of vinylpyridine, hydroxyalkyl (meth)acrylate, dimethylaminoalkyl (meth)acrylate, dimethylaminoalkyl styrene, ethylene glycol (meth)acrylate, ethylene glycol di(meth)acrylate, styrene-co-maleic anhydride and (meth)acrylic acid. Specifically, the polymer thin film may include the following repeating units.

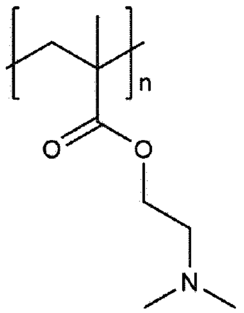

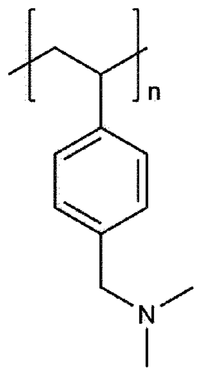

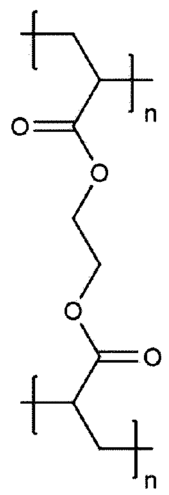

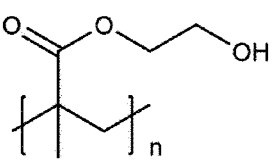

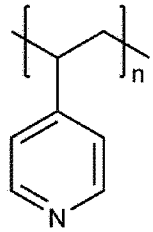

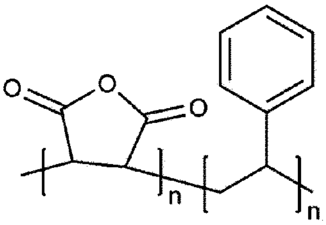

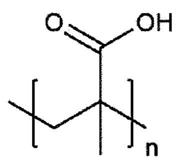

Among these, 2-vinylpyridine or 4-vinylpyridine can be preferably used as a monomer. The pyridine-based monomer has a high pKa, and thus can exhibit excellent alkali resistance.

By containing the repeating unit, the polymer thin film 20 has one or more functional groups selected from the group consisting of amine, hydroxyl, ester, acid anhydride, carboxyl, epoxy, and pyridine, and thus exhibits hydrophilicity.

The gas diffusion layer 100 for anion exchange membrane electrolysis may have a water contact angle of 50° or less. Since the gas diffusion layer of the present invention exhibits hydrophilicity, it is preferable that the lower limit of the water contact angle is not limited. Specifically, the water contact angle may be 40° or less, 30° or less, 20° or less, 10° or less, or 0°.

The water contact angle can be obtained by dropping a drop (10 $\mu\ell$) of distilled water on the surface of the gas diffusion layer before and after modification, photographing the droplet with a contact angle analyzer (DSA, KRUSS), and measuring the contact angle. The contact angle measurement method was in accordance with Korean Patent No. 1644025.

Further, the gas diffusion layer 100 for anion exchange membrane electrolysis may have a gas permeability of $1 \times 10^{-12}$ $m^2$ or more. The gas diffusion layer 100 for anion exchange membrane electrolysis of the present invention is a better product as the gas permeability is higher. Therefore, it is preferable that the upper limit thereof is not limited. Specifically, the gas permeability may be $1\times10$ $m^2$ or more, $5\times10^{-12}$ $m^2$ or more, $10\times10^{-12}$ $m^2$ or more, $30\times10^{-12}$ $m^2$ or more, $40\times10^{-12}$ $m^2$ or more, $50\times 10^{-12}$ $m^2$ or more, or $60\times10^{-12}$ $m^2$ or more, and $80\times10^{-12}$ $m^2$ or less, $70\times10^{-12}$ $m^2$ or less, or $65\times10^{-12}$ $m^2$ or less.

The gas permeability of the present invention was measured using a device for evaluating GDL basic physical properties (CPRT 10, Korea Institute of Energy Technology's own standard). By randomly contacting the GDL surface with an area of 0.332 $cm^2$ and performing measurements three times in total, the gas permeability can be determined using the following paper and Equation 1.

The gas permeability was determined using the Trough plane permeability method described in the paper "In-plane and through-plane gas permeability of carbon ber electrode backing layers (Jeff T. Gostick, et al., Sep 1 2006)," and the gas permeability (K, unit $m^2$) can be calculated according to the following [Equation 1].

[Equation 1]

$$K = \frac{\mu}{A/t}\frac{m}{P_1 - P_2}\left(\frac{RT}{MP_{agg}}\right)$$

in Equation 1,

K is the gas permeability ($m^2$),
$\mu$ is the dynamic viscosity of the gas used,
A is the area of the cross section through which gas permeated,
t is the thickness of the gas diffusion layer through which the gas penetrated,
m is the flow rate (mass) of gas flowing through a unit area,
$P_1$ is the pressure before gas permeation,
$P_2$ is the pressure after gas permeation,
R is the gas constant,
T is the temperature,
M is the weight of the gas used, and
$P_{avg}$ means the average value of $P_1$ and $P_2$.

Further, the gas diffusion layer 100 for anion exchange membrane electrolysis may have may have alkali resistance in a 1M KOH aqueous solution. Specifically, the gas diffusion layer 100 for anion exchange membrane electrolysis of the present invention does not lose its hydrophilicity even when stored in 1M KOH for 3 days, and decomposition or peeling of the thin film does not appear.

The porous support 10 contained in the gas diffusion layer 100 for anion exchange membrane electrolysis of the present invention is not limited as long as it is a porous material, but may be, for example, porous carbon in the form of cloth, felt, or paper, nickel or titanium in the form of mesh, or the like. Specifically, it may be porous carbon paper. In addition, the porous support may have a thickness of 100 to 500 $\mu$m.

FIG. 2 is a schematic diagram of a gas diffusion layer for anion exchange membrane electrolysis according to another embodiment of the present invention.

Referring to FIG. 2, the gas diffusion layer 100 for anion exchange membrane electrolysis may further comprise a microporous layer 30 containing polytetrafluoroethylene (PTFE) between the porous support 10 and the polymer thin film 20. The microporous layer 30 containing polytetrafluoroethylene (PTFE) may have a thickness of 50 to 200 $\mu$m.

In addition, according to the present invention, there can be provided a method for manufacturing the gas diffusion layer for anion exchange membrane electrolysis.

The method for manufacturing the gas diffusion layer for anion exchange membrane electrolysis of the present invention may comprise preparing a porous support (step 1); and forming a polymer thin film deposited on the whole or a part of the surface of the porous support using an initiated chemical vapor deposition (step 2).

The porous support in (step 1) is not limited as long as it is a porous material, but may be, for example, at least one selected from the group consisting of a porous carbon cloth, a porous carbon felt, a porous carbon paper, a nickel mesh, and a titanium mesh. Specifically, the porous support may be a porous carbon paper.

The initiated chemical vapor deposition (iCVD) used in the (step 2) is a process in which nanoscale polymeric thin films are deposited in the vapor phase on various types of substrates. This method allows a thin film to be deposited uniformly and has the characteristic that the surface of the substrate, namely, the gas diffusion layer, can be modified without affecting its porosity and electrical resistance. In particular, according to the present invention, a hydrophilic polymer thin film having high alkali resistance can be deposited on a porous support through an initiated chemical vapor deposition, thereby providing a method for manufacturing a gas diffusion layer for anion exchange membrane electrolysis through surface modification of a porous support, regardless of the presence or absence of a microporous layer.

Specifically, iCVD is a technique that causes polymerization of monomers by decomposing a gaseous initiator into radicals. Peroxides such as tert-butyl peroxide are mainly used as initiators, wherein such materials are volatile materials having a boiling point of about 110°C, which undergoes thermal decomposition at about 150°C. In addition to the initiator such as peroxide, which is decomposed by heat to form radicals, benzophenone, etc. which is decomposed by UV and light to form radicals, can also be used.

The iCVD process deposits a thin film using an energy supply such as a heated filament heat source or UV light. In particular, the iCVD process is performed at a low filament temperature between 180°C and 350°C, and the temperature of the substrate surface on which the polymer thin film is deposited can be maintained as low as 10 to 50°C. This has the advantage that since the substrate surface temperature can be maintained low, the porous support prepared in the (step 1) is subjected to a high-temperature process to thereby prevent occurrent of defects such as thermal shrinkage. In addition, since the process is performed in a vacuum state where the pressure in the chamber is between 0.01 and 1 Torr, high vacuum equipment is not required, and the monomer and initiator flow rates can be controlled using an injection valve.

In the (step 2), at least one functional group selected from the group consisting of amine, hydroxyl, ester, acid anhydride, carboxyl, epoxy, and pyridine can be used as a monomer for the polymer thin film.

Specifically, the monomer may include a pyridine-based vinyl or acrylate monomer, a hydroxyalkyl-based acrylate monomer, and a tertiary amine-based monomer.

For example, the polymer thin film may include repeating units derived from one or more monomers selected from the group consisting of vinylpyridine, hydroxyalkyl (meth)acrylate, dimethylaminoalkyl (meth)acrylate, dimethylaminoalkyl styrene, ethylene glycol (meth)acrylate, ethylene glycol di(meth)acrylate, styrene-co-maleic anhydride and (meth)acrylic acid.

Further, the (step 2) may be a step of using tert-butyl peroxide, tert-butyl peroxybenzoate, and the like as an initiator for the initiated chemical vapor deposition.

The (step 2) may be performed under a pressure in the reactor chamber of 0.01 Torr to 1 Torr. Specifically, the pressure in the reactor chamber may be 0.01 Torr or more, 0.1 Torr or more, 0.2 Torr or more, or 0.3 Torr or more, and 1 Torr or less, 0.8 Torr or less, 0.6 Torr or less, or 0.4 Torr or less. If the pressure in the reactor chamber is too low or too high, there may be a problem that the polymer thin film is not deposited on the porous support or the deposition rate is slowed.

The (step 2) may be performed at a substrate temperature in the reactor of 10 to 50°C. Specifically, it may be performed at a substrate temperature in the reactor of 10°C or more, 20°C or more, or 30°C or more, and 50°C or less, or 40°C or less. If the temperature of the substrate is less than 10°C, there may be a problem that the deposition uniformity of the polymer thin film decreases, and if the temperature of the substrate exceeds 50°C, there may be a problem that the deposition rate become slow.

In the (step 2), the monomer flow rate in the reactor may be 1 sccm to 10 sccm. Specifically, the monomer flow rate is 1 sccm or more, or 2 sccm or more, and 10 sccm or less, 5 sccm or less, or 4 sccm or less.

Further, in the (step 2), the initiator flow rate in the reactor may be 1 sccm to 5 sccm. Specifically, the initiator flow rate may be 1 sccm or more, and 5 sccm or less, 3 sccm or less, or 2 sccm or less.

If the monomer flow rate or the initiator flow rate is too low or high, the deposition thickness may become too thin or too thick even if the deposition time is sufficient.

The polymer thin film deposition of the (step 2) can be performed on one side or both sides of the porous support. When performed on both sides, the iCVD process can be performed repeatedly according to the above-mentioned conditions.

The polymer thin film deposited by the above manufacturing method in a form that covers the whole or at least

a part of the surface of the porous support is not formed as a sheet-shaped thin film on a porous support, but is deposited in a form that maintains the pore structure of the porous support. Thereby, the porous characteristics of the porous support can be maintained.

Hereinafter, preferable examples are presented for better understanding the present invention. However, the following examples are only for illustrating the present invention, and the present invention is not limited to or by them.

**Example**

Porous carbon paper (available from JNTG, product name: JNT20) was prepared as a porous support. Then, 4-vinyl pyridine (4-VP) (Aldrich, purity 95%) was placed as a monomer for the polymer thin film into a storage container of a custom-built iCVD reactor (Daeki Hi-Tech, iCVD system), and heated to 45°C. Then, tert-butyl peroxide (Aldrich, purity 98%) as the initiator was placed in an initiator container and maintained at room temperature. At this time, the initiator tert-butyl peroxide was flowed at a flow rate of 1.172 sccm, and the monomer 4-vinyl pyridine (4-VP) was flowed at a flow rate of 3.515 sccm. Porous carbon paper as the porous support was loaded into the reactor, and the temperature of the substrate inside the reactor was maintained at 30°C. In the state where the filament temperature was set to 140°C and the pressure was set to 0.3 Torr, the initiated chemical vapor deposition was performed on only one side of the porous support for 30 minutes, thereby obtaining a gas diffusion layer in which a 50 nm thick polymer thin film was formed on one surface of the porous carbon paper.

**Example 2**

Porous carbon paper (available from JNTG, product name: JNT20-A6H) in which a microporous layer containing PTFE was formed on one surface was prepared. JNT20-A6H has a thickness of 250$\pm$20 $\mu$m, can be operated under high humidity conditions, has an electrical resistance of 10 mOhm·cm$^2$ or less, and a density of 100$\pm$10 g/m$^2$.

Subsequently, a polymer thin film was formed on the microporous layer containing PTFE using the same method and flow rate as in Example 1 to obtain a gas diffusion layer.

**Example 3**

A multilayered GDL (available from JNTG, product name: JNT20-A3) in which a microporous layer containing PTFE was coated onto a porous carbon paper was prepared. JNT20-A3 has a thickness of 250 $\pm$ 20 $\mu$m, can be operated under high humidity conditions, has an electrical resistance of 15 mOhm·cm$^2$ or less, and a density of 95 $\pm$ 10 g/m$^2$.

Subsequently, a polymer thin film was formed on the microporous layer containing PTFE using the same method and flow rate as in Example 1 to obtain a gas diffusion layer.

**Example 4**

A multilayered GDL (available from JNTG, product name: JNT20-A6L) in which a microporous layer containing PTFE was coated onto a porous carbon paper was prepared. JNT20-A6L has a thickness of 250 $\pm$ 20 $\mu$m, can be operated under low humidity conditions, has an electrical resistance of 10 mOhm·cm$^2$ or less, and a density of 95 $\pm$ 10 g/m$^2$.

Subsequently, a polymer thin film was formed on the microporous layer containing PTFE using the same method and flow rate as in Example 1 to obtain a gas diffusion layer.

**Comparative Example 1**

A clean porous carbon paper on which no microporous layer or thin polymer film was formed was prepared in Comparative Example 1.

**Comparative Example 2**

A porous carbon paper (available from JNTG, product name: JNT20-A6H) on which a microporous layer containing PTFE was formed on one surface was prepared in Comparative Example 2.

**Comparative Example 3**

A porous carbon paper (available from JNTG, product name: JNT20-A3) on which a microporous layer containing PTFE was formed on one surface was prepared in Comparative Example 3.

**Comparative Example 4**

A porous carbon paper (available from JNTG, product name: JNT20-A6L & A6H) on which a microporous layer containing PTFE was formed on one surface was prepared in Comparative Example 4.

**Experimental Example 1 - Surface observation of porous support before and after polymer thin film deposition**

The surfaces of Example 1 and Comparative Example 1 were observed using SEM, and the results were shown in FIG. 3.

It could be confirmed that no changes were observed in the surface of Comparative Example 1 and the surface of Example 1, particularly, no changes were seen in porosity.

**Experimental Example 2 - Measurement of contact angle**

The contact angles of the gas diffusion layers of Example 1, Example 2, Comparative Example 1, and Comparative Example 2 were measured. The contact angle was measured by dropping a drop (10 $\mu\ell$) of distilled water on the surface of the gas diffusion layer before and after modification using a contact angle analyzer (DSA, KRUSS).

As a result, in the case of Example 1, the contact angle was 0°, confirming that the surface was modified to be superhydrophilic (FIG. 6). It could be seen that in the case of Example 2, even though the PTFE microporous layer was included as an intermediate layer, the contact angle was measured to be 40°, still exhibiting hydrophilicity (FIG. 7).

On the other hand, it could be seen that in the case of Comparative Example 1, the contact angle was 128° (FIG. 4), and in the case of Comparative Example 2, the contact angle was 156° (FIG. 5), both exhibiting hydrophobicity.

From these results, it was found that the gas diffusion layer containing the polymer thin film according to the present invention is hydrophilic and has a well-modified surface, and thus is suitable for use in anion exchange membrane electrolysis.

**Experimental Example 3 - Alkali resistance test**

The alkali resistance of the gas diffusion layer formed with the polymer thin film of Example 1 was tested.

In order to be similar to the environment when using in anion exchange membrane electrolysis, the gas diffusion layer of Example 1 was immersed in a 1M KOH aqueous solution for 3 days, and then contact angle measurement and FT-IR peak change measurement were performed.

The contact angle was measured in the same manner as in Experimental Example 2, and the contact angle was measured to be 0° both before and after alkali resistance test, confirming that it still has superhydrophilic surface properties.

FT-IR was measured before and after alkali resistance test using an FT-IR spectrometer (ALPHA FT-IR Spectrometer, BRUKER), and the resulting peaks were shown in FIG. 8. Pyridine peaks were detected at 1415 $cm^{-1}$ and 1596 $cm^{-1}$ at the same level before and after the alkali resistance test, confirming that no change occurred in the composition of the polymer thin film.

In conclusion, it was found that even when the gas diffusion layer of the present invention is used for anion exchange membrane electrolysis under strong alkaline conditions, the polymer thin film does not disappear nor change in the composition, and will sustain the sufficient wettability.

**Experimental Example 4 - Observation of compression rate versus average electrical resistance**

The compression rate versus the electrical resistance of each set of Example 1 and Comparative Example 1, Example 2 and Comparative Example 2, Example 3 and Comparative Example 3, and Example 4 and Comparative Example 4 was observed. A comparison between Example 1 and Comparative Example 1 is shown in FIG. 9, a comparison between Example 2 and Comparative Example 2 is shown in FIG. 10, a comparison between Example 3 and Comparative Example 3 is shown in FIG. 11, and a comparison between Example 4 and Comparative Example 4 is shown in FIG. 12. The overall data is shown in Table 1 below.

The compression rate versus the electrical resistance of the present invention was measured using a device for evaluating GDL basic physical properties (CPRT 10, Korea Institute of Energy Technology's own standard). By randomly contacting the GDL surface with an area of 4.799 $cm^2$ and performing measurements three times in total. The measurement was performed in the compression rate range from 0.25 to 10 $kgf/cm^2$.

FIGS. 9 to 12 showed that in the case of Examples 1 to 4 in which polymer thin films were deposited, the electrical resistance slightly increased at all compression rates, but this was a very small increase, and was not enough to affect the use of anion exchange membrane electrolysis. In particular, there is little difference when the compression

rate increases, which is the environment in which water electrolysis cells are assembled, confirming that the anion exchange membrane is suitable for use in water electrolysis.

[Table 1]

| | Average resistance (mOhm*cm$^2$) | | | |
|---|---|---|---|---|
| Compression rate (kgf/m$^2$) | 1 | 2 | 6 | 10 |
| Example 1 | 55.4 | 27.5 | 8 | 6.9 |
| Example 2 | 120.8 | 57.4 | 18.1 | 10.6 |
| Example 3 | 97.7 | 52.3 | 18.4 | 11 |
| Example 4 | 77.1 | 41.3 | 14.7 | 9.3 |
| Comparative Example 1 | 55.4 | 27.5 | 8.2 | 6.6 |
| Comparative Example 2 | 108.6 | 53.8 | 16.8 | 10.2 |
| Comparative Example 3 | 93.1 | 50.1 | 17.1 | 10.2 |
| Comparative Example 4 | 76.9 | 38.2 | 13.1 | 8.8 |

**Experimental Example 5 - Observation of gas permeability**

The gas permeabilities of Example 1 and Comparative Example 1, Example 2 and Comparative Example 2, Example 3 and Comparative Example 3, and Example 4 and Comparative Example 4 were observed, and the results are shown in FIG. 13 and Table 2.

The gas permeability of the present invention was measured using a device for evaluating GDL basic physical properties (CPRT 10, Korea Institute of Energy Technology's own standard). By randomly contacting the GDL surface with an area of 0.332 cm$^2$ and performing measurements three times in total, the gas permeability can be determined using the following paper and Equation 1.

The gas permeability was determined using the Trough plane permeability method described in the paper "In-plane and through-plane gas permeability of carbon ber electrode backing layers (Jeff T. Gostick, et al., Sep 1 2006)," and the gas permeability (K, unit m$^2$) was calculated according to the following [Equation 1], and shown in FIG. 4.

[Equation 1]

$$K = \frac{\mu}{A/t}\frac{m}{P_1 - P_2}\left(\frac{RT}{MP_{agg}}\right)$$

in Equation 1,

K is the gas permeability,
$\mu$ is the dynamic viscosity of the gas used,
A is the area of the cross section through which gas permeated,
t is the thickness of the gas diffusion layer through which the gas penetrated,
m is the flow rate (mass) of gas flowing through a unit area,
$P_1$ is the pressure before gas permeation,
$P_2$ is the pressure after gas permeation,
R is the gas constant,
T is the temperature,
M is the weight of the gas used, and
$P_{avg}$ means the average value of $P_1$ and $P_2$.

According to FIG. 13, it was confirmed that there was no difference in gas permeability before and after deposition of the polymer thin film.

[Table 2]

| | Gas permeability ($m^2$) |
|---|---|
| Example 1 | 62.22 |
| Example 2 | 1.3 |
| Example 3 | 5.41 |
| Example 4 | 1.22 |
| Comparative Example 1 | 60.56 |
| Comparative Example 2 | 1.16 |
| Comparative Example 3 | 5.79 |
| Comparative Example 4 | 1.25 |

[Description of Reference Numerals]

100: gas diffusion layer
10: porous support
20: polymer thin film
30: microporous layer

## Claims

**1.** A gas diffusion layer for anion exchange membrane electrolysis comprising:

a porous support; and
a polymer thin film deposited on the whole or a part of the surface of the porous support,
wherein the polymer thin film includes at least one functional group selected from the group consisting of amine, hydroxyl, ester, acid anhydride, carboxyl, epoxy, and pyridine.

**2.** The gas diffusion layer for anion exchange membrane electrolysis according to claim 1, wherein:
the polymer thin film includes repeating units derived from one or more monomers selected from the group consisting of vinylpyridine, hydroxyalkyl (meth)acrylate, dimethylaminoalkyl (meth)acrylate, dimethylaminoalkyl styrene, ethylene glycol (meth)acrylate, ethylene glycol di(meth)acrylate, styrene-co-maleic anhydride and (meth)acrylic acid.

**3.** The gas diffusion layer for anion exchange membrane electrolysis according to claim 1, wherein:
the gas diffusion layer for anion exchange membrane electrolysis has a contact angle with water of 50° or less.

**4.** The gas diffusion layer for anion exchange membrane electrolysis according to claim 1, wherein:
the gas diffusion layer for anion exchange membrane electrolysis has a gas permeability of $1 \times 10^{-12}$ $m^2$ or more.

**5.** The gas diffusion layer for anion exchange membrane electrolysis according to claim 1, wherein:
the gas diffusion layer for anion exchange membrane electrolysis has alkali resistance in a 1M KOH aqueous solution.

**6.** The gas diffusion layer for anion exchange membrane electrolysis according to claim 1, wherein:
the porous support is at least one selected from the group consisting of a porous carbon cloth, a porous carbon felt, a porous carbon paper, a nickel mesh, and a titanium mesh.

**7.** The gas diffusion layer for anion exchange membrane electrolysis according to claim 1, further comprising a microporous layer containing polytetrafluoroethylene between the porous support and the polymer thin film.

**8.** A method for manufacturing a gas diffusion layer for anion exchange membrane electrolysis, the method comprising:

preparing a porous support (step 1); and forming a polymer thin film deposited on the whole or a part of the surface of the porous support using an initiated chemical vapor deposition (step 2),
wherein the (step 2) is a step of using a monomer containing at least one functional group selected from the group consisting of amine, hydroxyl, ester, acid anhydride, carboxyl, epoxy, and pyridine as a monomer for the polymer thin film.

**9.** The method for manufacturing a gas diffusion layer for anion exchange membrane electrolysis according to claim 8, wherein:
the monomer for the polymer thin film in the (step 2) is at least one selected from the group consisting of vinylpyridine, hydroxyalkyl (meth)acrylate, dimethylaminoalkyl (meth)acrylate, dimethylaminoalkyl styrene, ethylene glycol (meth)acrylate, ethylene glycol di(meth)acrylate, styrene-co-maleic anhydride and (meth)acrylic acid-based monomers.

**10.** The method for manufacturing a gas diffusion layer for anion exchange membrane electrolysis according to claim 8, wherein:
the (step 2) is a step of using at least one selected from the group consisting of tert-butyl peroxide and tert-butyl peroxybenzoate as an initiator for the initiated chemical vapor deposition.

**11.** The method for manufacturing a gas diffusion layer for anion exchange membrane electrolysis according to claim 8, wherein:
the (step 2) is performed under a pressure in the reactor chamber of 0.01 to 1 Torr.

**12.** The method for manufacturing a gas diffusion layer for anion exchange membrane electrolysis according to claim 8, wherein:
the (step 2) is performed at a substrate temperature in the reactor of 10 to 50°C.

**13.** The method for manufacturing a gas diffusion layer for anion exchange membrane electrolysis according to claim 8, wherein:
in the (step 2), a monomer flow rate in the reactor is 1 sccm to 10 sccm.

**14.** The method for manufacturing a gas diffusion layer for anion exchange membrane electrolysis according to claim 8, wherein:
in the (step 2), an initiator flow rate in the reactor is 1 sccm to 5 sccm.

【FIG. 1】

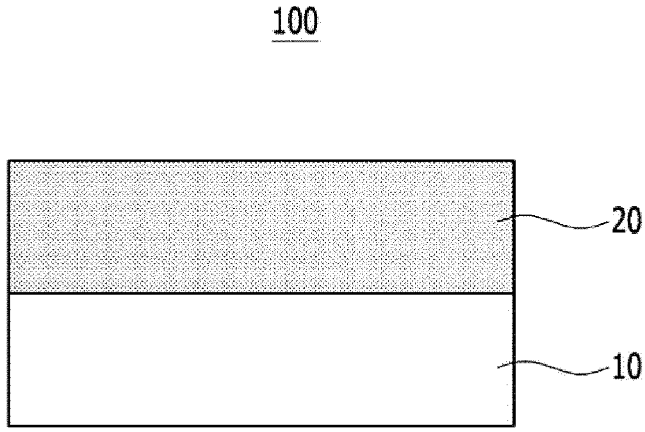


【FIG. 2】

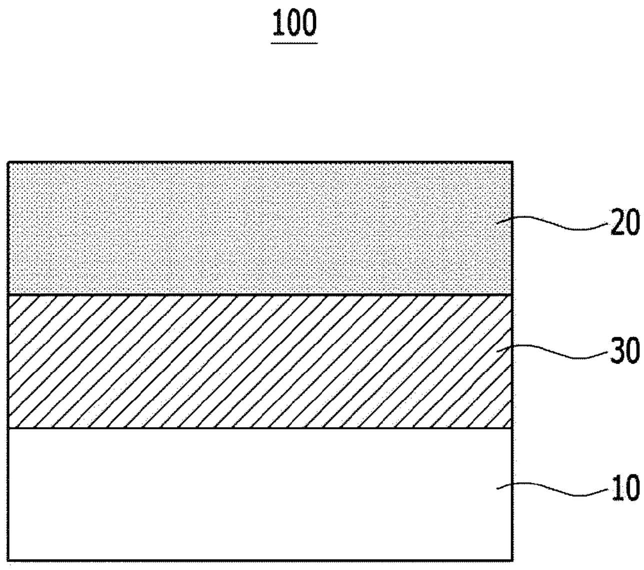

【FIG. 3】

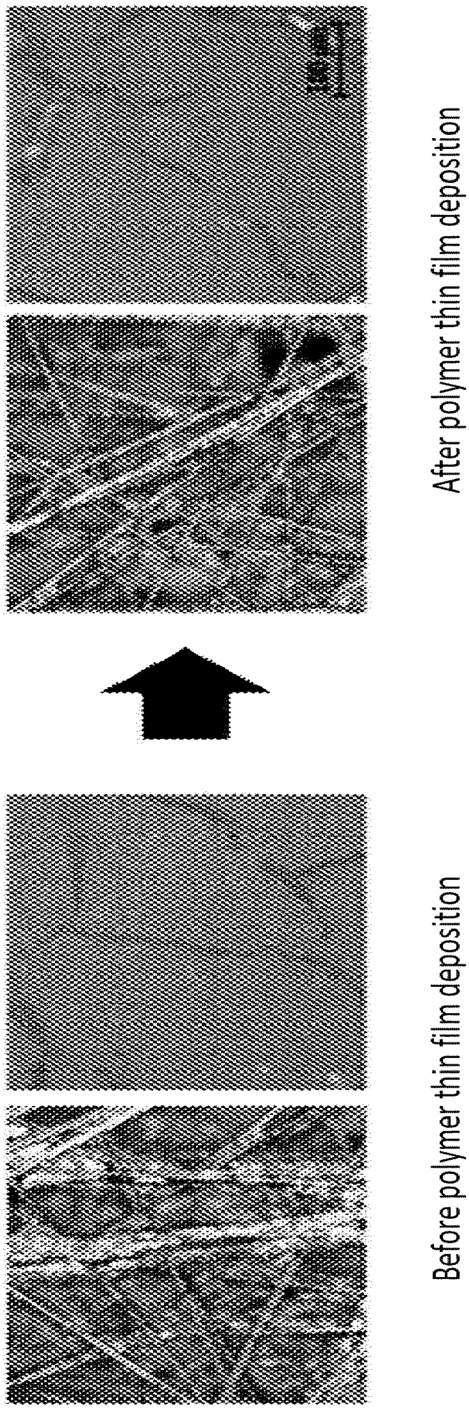
After polymer thin film deposition
Before polymer thin film deposition

【FIG. 4】

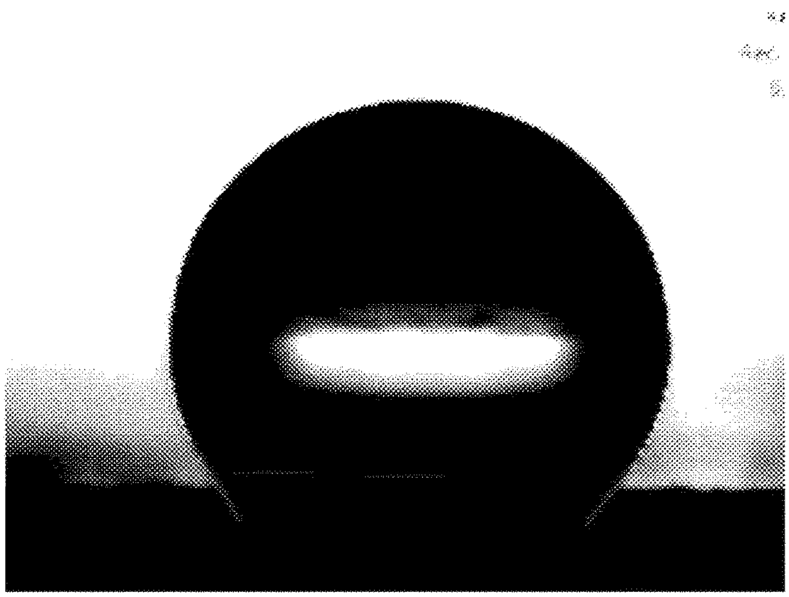

【FIG. 5】

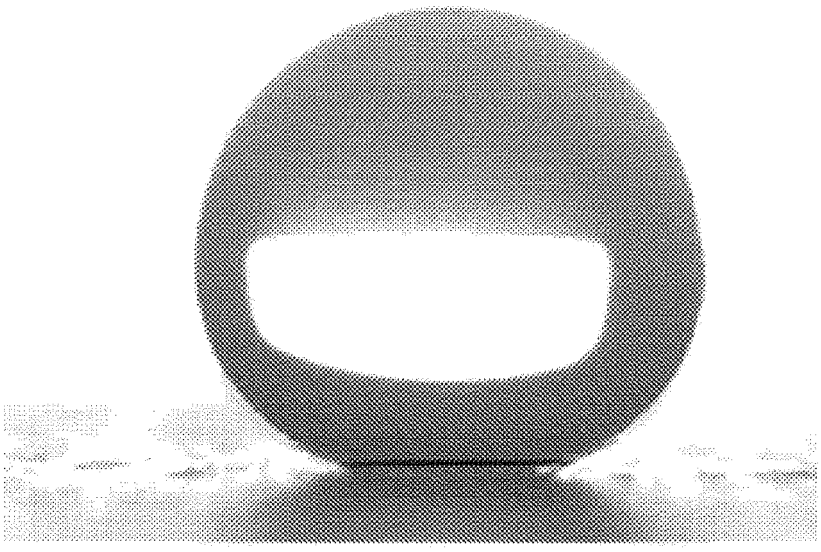

【FIG. 6】

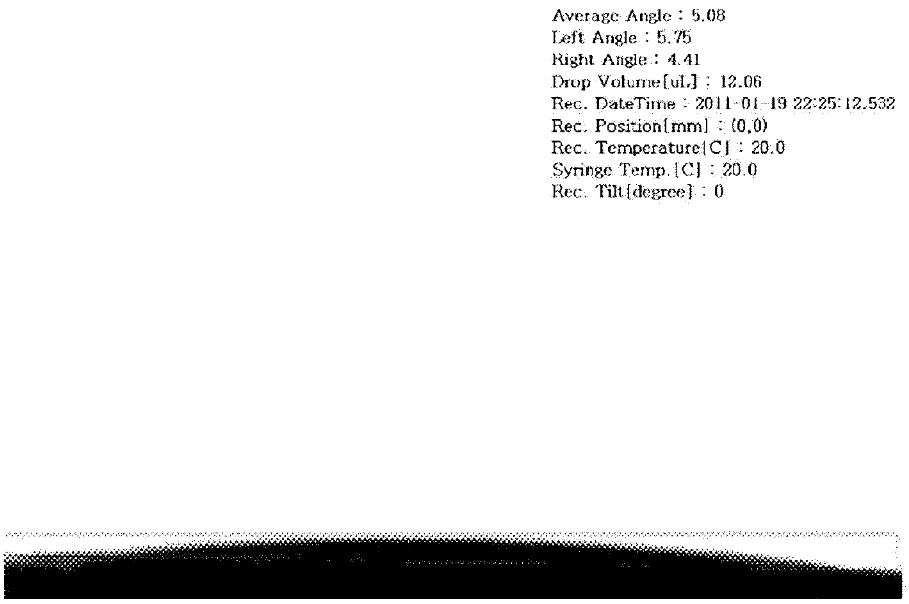
Average Angle : 5.08
Left Angle : 5.75
Right Angle : 4.41
Drop Volume[uL] : 12.06
Rec. DateTime : 2011-01-19 22:25:12.532
Rec. Position[mm] : (0,0)
Rec. Temperature[C] : 20.0
Syringe Temp.[C] : 20.0
Rec. Tilt[degree] : 0

【FIG. 7】

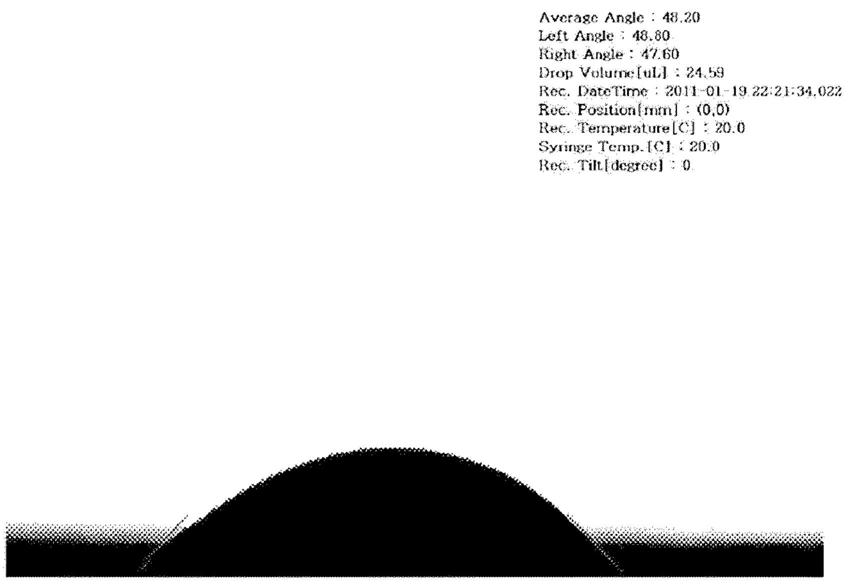
Average Angle : 48.20
Left Angle : 48.80
Right Angle : 47.60
Drop Volume[uL] : 24.59
Rec. DateTime : 2011-01-19 22:21:34.022
Rec. Position[mm] : (0,0)
Rec. Temperature[C] : 20.0
Syringe Temp.[C] : 20.0
Rec. Tilt[degree] : 0

【FIG. 8】

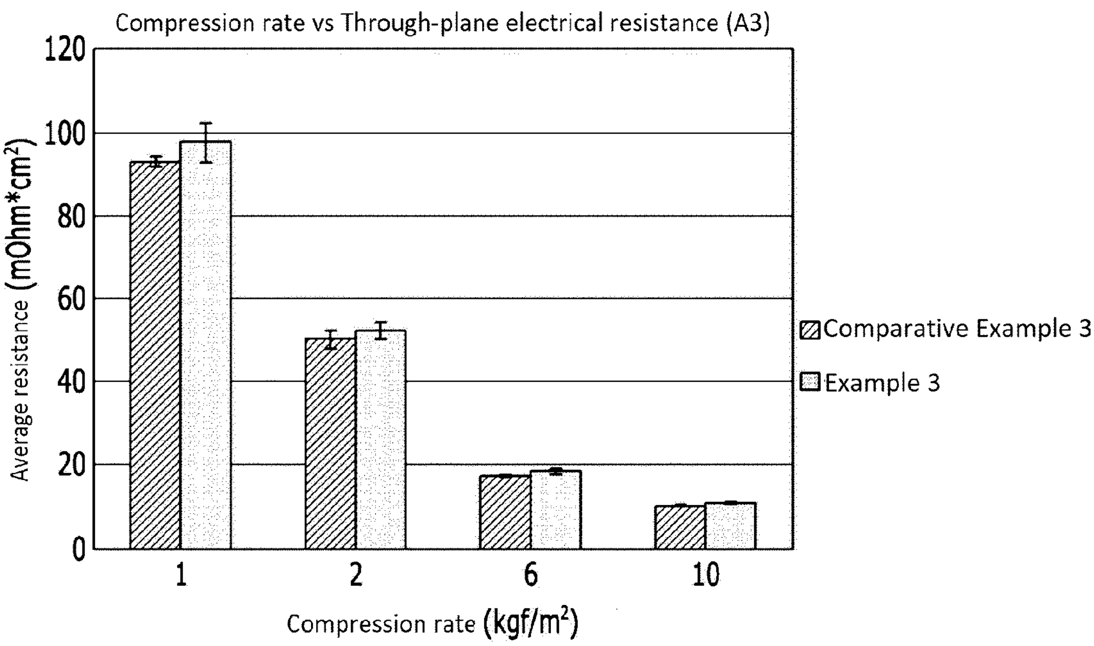
Compression rate vs Through-plane electrical resistance (A3)
Average resistance (mOhm*cm²)
120
100
80
60
40
20
0
1
2
6
10
Compression rate (kgf/m²)
Comparative Example 3
Example 3

【FIG.9】

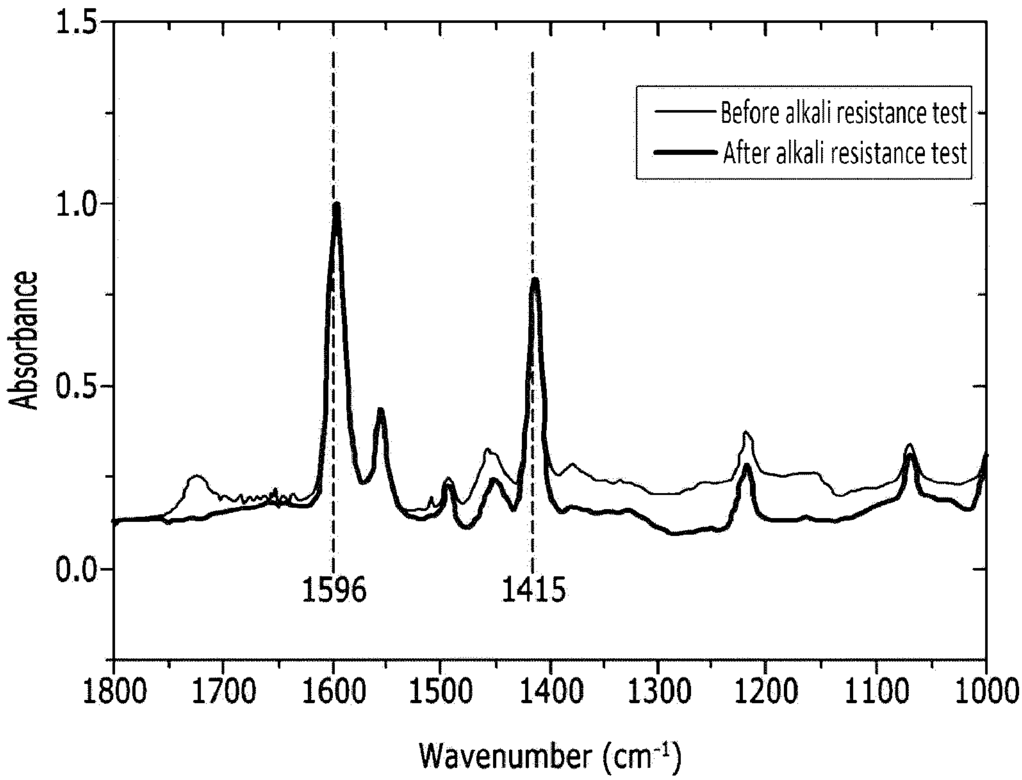
Before alkali resistance test
After alkali resistance test
Absorbance
1.5
1.0
0.5
0.0
1596
1415
1800
1700
1600
1500
1400
1300
1200
1100
1000
Wavenumber (cm⁻¹)

【FIG. 10】

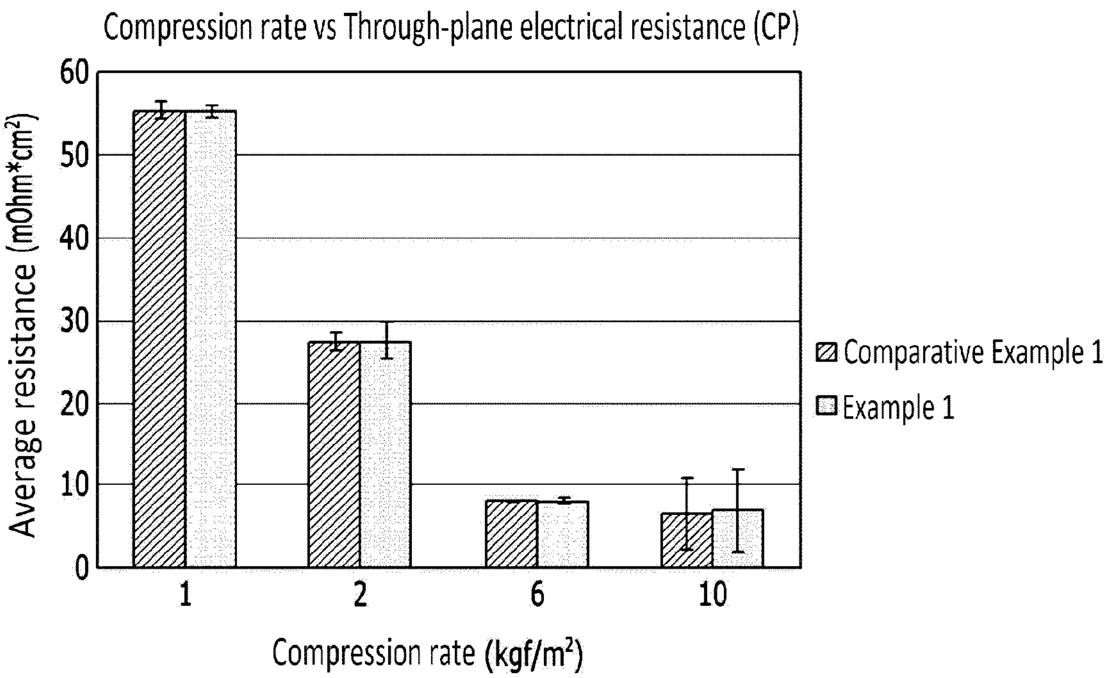
Compression rate vs Through-plane electrical resistance (CP)
Average resistance (mOhm*cm²)
60
50
40
30
20
10
0
1
2
6
10
Compression rate (kgf/m²)
Comparative Example 1
Example 1

【FIG. 11】

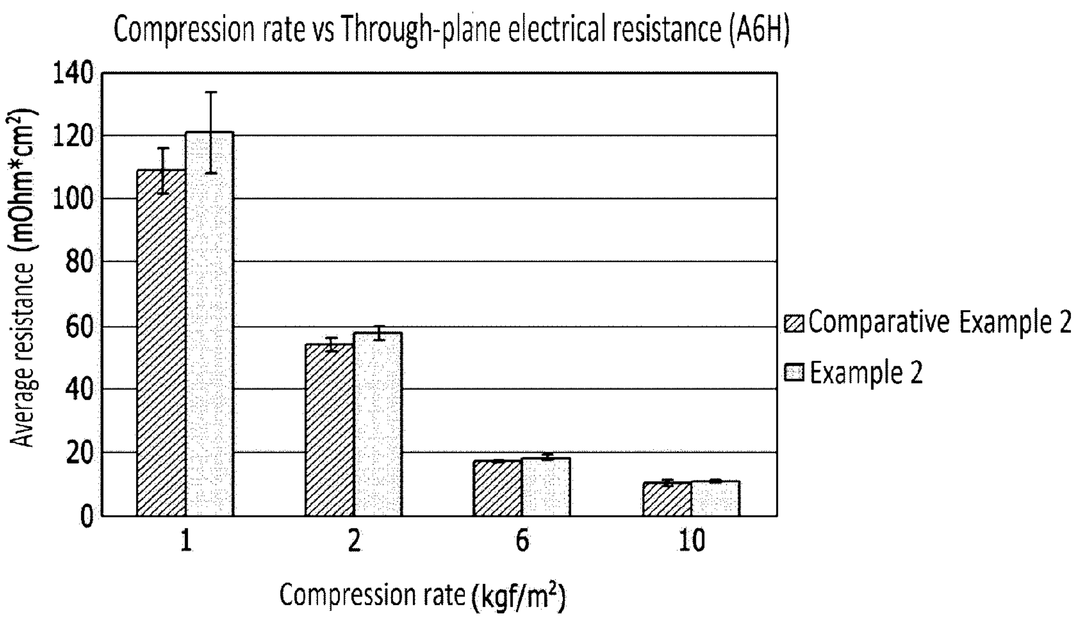
Compression rate vs Through-plane electrical resistance (A6H)
Average resistance (mOhm*cm²)
140
120
100
80
60
40
20
0
1
2
6
10
Compression rate (kgf/m²)
Comparative Example 2
Example 2

【FIG. 12】

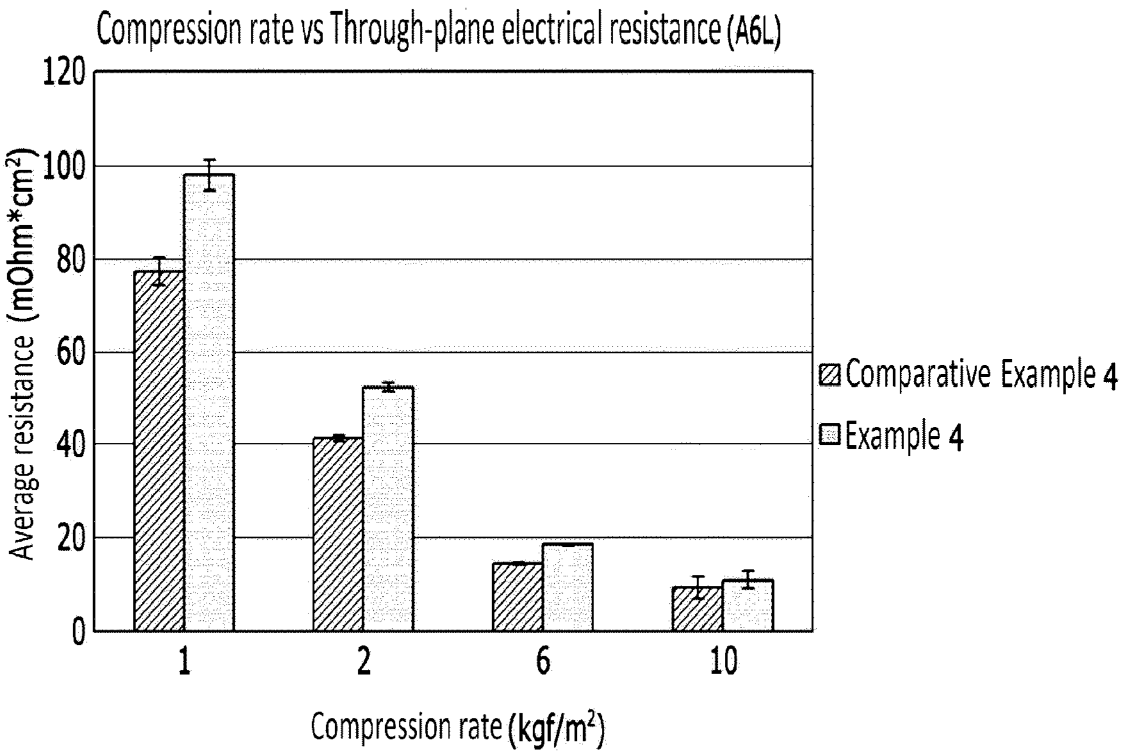
Compression rate vs Through-plane electrical resistance (A6L)
Average resistance (mOhm*cm²)
120
100
80
60
40
20
0
1
2
6
10
Compression rate (kgf/m²)
Comparative Example 4
Example 4

【FIG. 13】

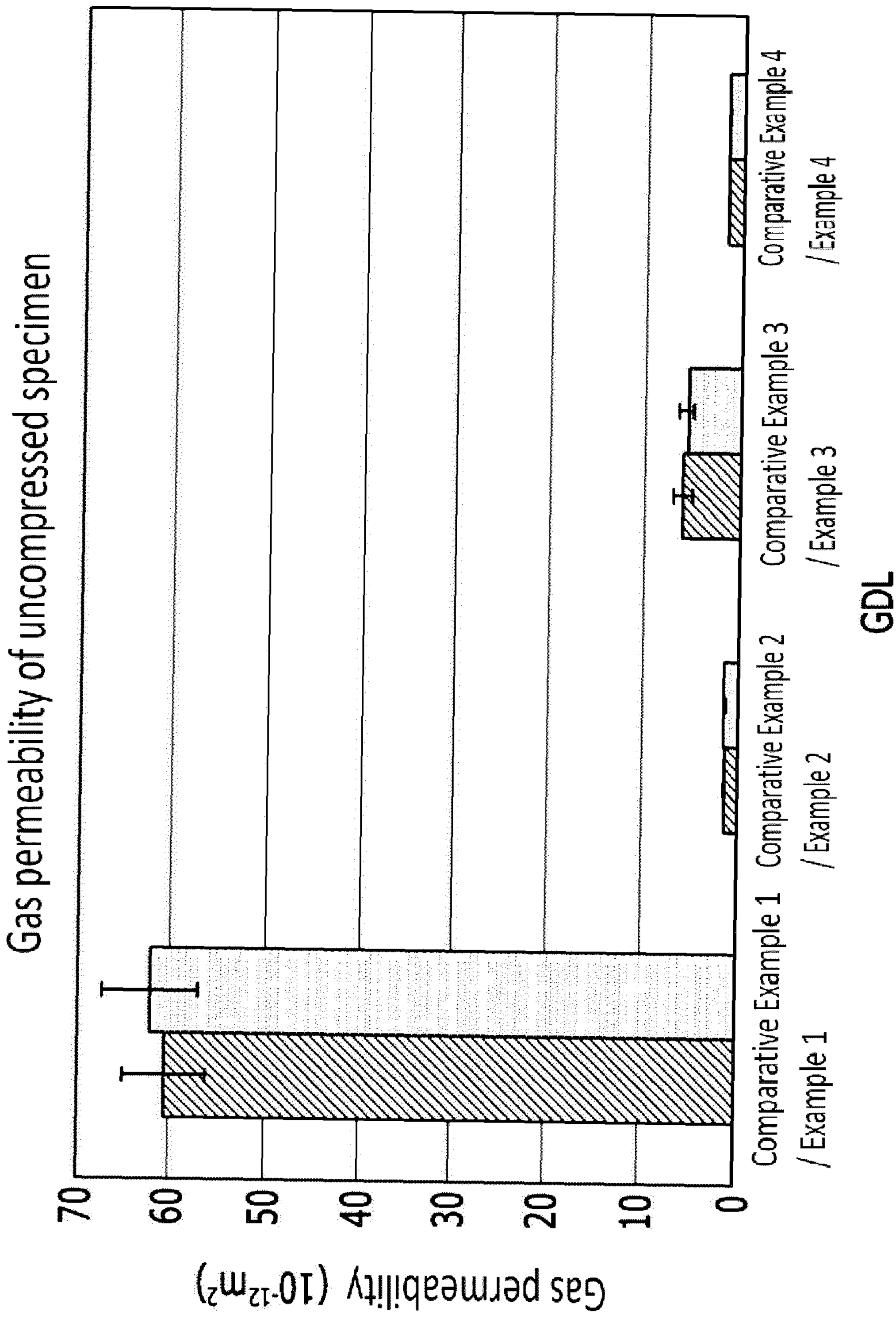
Gas permeability of uncompressed specimen
Gas permeability (10-12m2)
70
60
50
40
30
20
10
0
Comparative Example 1 / Example 1
Comparative Example 2 / Example 2
Comparative Example 3 / Example 3
Comparative Example 4 / Example 4
GDL

**INTERNATIONAL SEARCH REPORT**

International application No. **PCT/KR2022/019144**

**A. CLASSIFICATION OF SUBJECT MATTER**

**C25B 11/032**(2021.01)i; **C25B 1/04**(2006.01)i; **C23C 16/448**(2006.01)i

According to International Patent Classification (IPC) or to both national classification and IPC

**B. FIELDS SEARCHED**

Minimum documentation searched (classification system followed by classification symbols)

C25B 11/032(2021.01); B01D 17/02(2006.01); B01D 71/06(2006.01); C25B 1/04(2006.01); C25B 11/03(2006.01); C25B 9/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 음이온교환막 수전해(anion exchange membrane water electrolysis), 기체 확산층(gas diffusion layer), 다공성 지지체(porous support), 고분자 박막(polymer thin film), 증착(deposition), 친수성(hydrophilic), 비닐피리딘(vinylpyridine), 내알칼리성(alkali resistance)

**C. DOCUMENTS CONSIDERED TO BE RELEVANT**

| Category* | Citation of document, with indication, where appropriate, of the relevant passages | Relevant to claim No. |
|---|---|---|
| A | KR 10-2212534 B1 (INDUSTRIE DE NORA S.P.A.) 09 February 2021 (2021-02-09)<br>See claim 1; and paragraph [0020]. | 1-14 |
| A | KR 10-2017-0141466 A (KOREA ADVANCED INSTITUTE OF SCIENCE AND TECHNOLOGY et al.) 26 December 2017 (2017-12-26)<br>See entire document. | 1-14 |
| A | KR 10-2017-0035735 A (KOREA ELECTRIC POWER CORPORATION et al.) 31 March 2017 (2017-03-31)<br>See entire document. | 1-14 |
| A | LÓPEZ-FERNÁNDEZ, E. et al. Recent Advances in Alkaline Exchange Membrane Water Electrolysis and Electrode Manufacturing. Molecules, a journal of synthetic chemistry and natural product Chemistry. 2021 (20 October 2021), vol. 26, no. 21, p. 6326 (inner pp. 1-24).<br>See entire document. | 1-14 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **07 March 2023** | **07 March 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.
**PCT/KR2022/019144**

**C. DOCUMENTS CONSIDERED TO BE RELEVANT**

| Category* | Citation of document, with indication, where appropriate, of the relevant passages | Relevant to claim No. |
|---|---|---|
| A | 김숭연 등. 알카라인 연료전지 가스확산층 내구성 향상을 위한 초발수 코팅 최적화 연구. 공업화학. 2017, vol. 28, no. 6, pp. 691-695 (KIM, Soong Yeon et al. Study on the Optimization of Superhydrophobic Coating for the Durability of Gas Diffusion Layer in Alkaline Fuel Cells. Applied Chemistry for Engineering.)<br>See entire document. | 1-14 |

Form PCT/ISA/210 (second sheet) (July 2022)

**INTERNATIONAL SEARCH REPORT**
**Information on patent family members**

International application No.
**PCT/KR2022/019144**

| Patent document cited in search report | Publication date (day/month/year) | Patent family member(s) | Publication date (day/month/year) |
|---|---|---|---|
| KR 10-2212534 B1 | 09 February 2021 | AR 092998 A1 | 13 May 2015 |
| | | AU 2013-334007 A1 | 12 March 2015 |
| | | AU 2013-334007 B2 | 31 August 2017 |
| | | CN 104662203 A | 27 May 2015 |
| | | CN 104662203 B | 05 June 2018 |
| | | DK 2909363 T3 | 30 July 2018 |
| | | EP 2909363 A1 | 26 August 2015 |
| | | EP 2909363 B1 | 30 May 2018 |
| | | ES 2678268 T3 | 09 August 2018 |
| | | IL 237320 A | 30 April 2015 |
| | | IT MI20121736 A1 | 17 April 2014 |
| | | JP 2015-536383 A | 21 December 2015 |
| | | JP 6324392 B2 | 16 May 2018 |
| | | KR 10-2015-0070293 A | 24 June 2015 |
| | | TW 201419647 A | 16 May 2014 |
| | | US 10968526 B2 | 06 April 2021 |
| | | US 2015-0240368 A1 | 27 August 2015 |
| | | UY 35080 A | 30 May 2014 |
| | | WO 2014-060417 A1 | 24 April 2014 |
| KR 10-2017-0141466 A | 26 December 2017 | None | |
| KR 10-2017-0035735 A | 31 March 2017 | KR 10-1762506 B1 | 27 July 2017 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020210169323
- KR 1644025


### Non-patent literature cited in the description


- **JEFF T. GOSTICK et al.** *In-plane and through-plane gas permeability of carbon ber electrode backing layers,* 01 September 2006